# DEMANDE DE BREVET EUROPEEN

(11) **EP 3 309 841 A1**
(43) Date de publication de la demande: **18.04.2018**
(21) Numéro de dépôt: 17196060.2
(22) Date de dépôt: 12.10.2017
(51) Int. Cl.: H01L 29/16, H01L 29/45, H01L 29/66

(54) **PROCEDE DE REALISATION D'UN CONTACT ELECTRIQUE SUR UNE COUCHE DE GRAPHITE, CONTACT OBTENU A L'AIDE D'UN TEL PROCEDE ET DISPOSITIF ELECTRONIQUE UTILISANT UN TEL CONTACT**

(30) Priorité: 13.10.2016 FR 1659890
(71) Demandeur: Commissariat à l'Energie Atomique et aux Energies Alternatives, 75015 Paris (FR)
(72) Inventeur: RENARD, Vincent, 38500 LA BUISSE (FR); LE QUANG, Toai, 38000 GRENOBLE (FR); CHAPELIER, Claude, 38420 DOMENE (FR)
(74) Mandataire: Cabinet Camus Lebkiri

(57) **Abrégé**

La présente invention concerne un procédé de réalisation de contact électrique (20,40) et en particulier un procédé de réalisation d'un contact électrique (20,40) sur une couche de graphite (3) déposé sur un substrat (1) en carbure. La présente invention concerne également un procédé de réalisation d'un dispositif électronique à base de graphite. L'invention concerne en outre un contact électrique (20,40) ou un dispositif électronique susceptible d'être obtenu par lesdits procédés. L'invention met notamment en oeuvre un traitement thermique impliquant un empilement comportant un substrat (1) de carbure et une couche métallique (2') apte à former une couche de carbure interstitiel. Lors de ce traitement thermique, la couche métallique (2') réagit avec le substrat (1) de carbure pour former une couche de carbure interstitiel (2) ainsi qu'une couche de graphite (3) à la surface de ladite couche de carbure interstitiel (2).

## Description

### DOMAINE TECHNIQUE DE L'INVENTION

Le domaine technique de l'invention est celui de l'électronique. La présente invention concerne un procédé de réalisation d'un contact électrique et en particulier un procédé de réalisation d'un contact électrique sur du graphite déposé sur un substrat en carbure. La présente invention concerne également un procédé de réalisation d'un dispositif électronique à base de graphite. L'invention concerne en outre un contact électrique ou un dispositif électronique susceptible d'être obtenu par lesdits procédés.

### ARRIERE-PLAN TECHNOLOGIQUE DE L'INVENTION

Le graphite, par exemple sous la forme d'une ou plusieurs feuilles de graphène, est aujourd'hui un élément amené à jouer un rôle essentiel dans le domaine de la microélectronique ou bien encore de la spintronique. Afin d'obtenir une couche de graphite de bonne qualité, plusieurs techniques ont été envisagées. Il est notamment connu de produire une couche de graphite à partir d'un substrat en carbure de silicium. Il est pour cela nécessaire de chauffer le substrat à une température supérieure à la température de dissociation du carbure de silicium. En effet, lors d'un tel traitement thermique, une couche de graphite se forme à la surface dudit substrat, l'épaisseur de cette couche dépendant de la durée du traitement thermique et de la température appliquée au substrat. Il a été également montré qu'il était possible de recourir à un tel procédé avec un substrat de carbure d'aluminium moyennant des températures de traitement plus élevées. En revanche, il n'existe à l'heure actuelle aucune technique permettant de réaliser, à l'aide d'un traitement thermique, du graphite sur une couche de carbure dit interstitiel, c'est-à-dire un carbure pour lequel les atomes de carbone s'insèrent dans les interstices entre les atomes de métal tels que le Titane (Ti), le Zirconium (Zr), le Hafnium (Hf), le Vanadium (V), le Niobium (Nb), le Tantale (Ta), le Chrome (Cr), le Molybdène (Mo) ou le Tungstène (W). En outre, la température de dissociation d'un tel carbure étant très élevée, un procédé similaire impliquerait donc l'utilisation de températures très élevées, ce qui n'est pas sans poser de problème en termes de fabrication et de coût énergétique.

Le problème d'obtention d'une couche de graphite de bonne qualité n'est pas la seule difficulté rencontrée dans la fabrication de dispositifs à base de graphite. Il est également difficile de réaliser des contacts électriques permettant de connecter électriquement une couche de graphite. Afin de définir de tels contacts, il est connu de déposer une couche métallique à la surface de la couche de graphite à contacter puis de structurer la couche métallique afin de former un ou plusieurs contacts. Mais, bien qu'une connexion électrique soit établie par cette technique, cette dernière est très souvent de mauvaise qualité. Autrement dit, une résistance électrique élevée existe entre la couche métallique formant le contact et la couche de graphite que l'on cherche à contacter. Afin d'améliorer la qualité de ces contacts, il est donc connu d'effectuer des traitements de surface comme cela est par exemple décrit dans l'article de H.Y Park et Al, Adv. Mater. 28, 864 (2016), ce qui impose des étapes de procédé supplémentaires souvent complexes. De plus, comme évoqué précédemment, il est également nécessaire de structurer la couche métallique afin de former les différentes connexions. Ces différentes contraintes ne sont pas sans poser de difficultés tant en terme de coût qu'en termes d'industrialisation, les procédés utilisés n'étant que très difficilement transposables dans un environnement de production industrielle.

Il existe donc un besoin d'un procédé permettant d'obtenir une couche de graphite sur une couche de carbure interstitiel par traitement thermique. Il existe également un besoin concernant un procédé permettant de contacter une couche de graphite ne nécessitant pas d'opération de traitement de surface complexe et coûteuse.

### RESUME DE L'INVENTION

L'invention offre une solution aux problèmes évoqués précédemment, en permettant d'obtenir une couche de graphite sur une couche de carbure interstitiel par un traitement thermique impliquant un empilement comportant un substrat de carbure et une couche métallique apte à former une couche de carbure interstitiel.

Le procédé offre en outre la possibilité d'obtenir un contact présentant une faible résistance entre un carbure interstitiel et une couche de graphite. Un tel contact peut donc être utilisé par la suite afin de fabriquer un dispositif électronique à base de graphite.

Pour cela, un premier aspect de l'invention concerne un procédé de fabrication d'une couche de graphite sur une couche de carbure interstitiel comprenant :
- une étape de dépôt d'une couche métallique formée de un ou plusieurs métaux sur un substrat en carbure, la couche métallique étant apte à former un carbure interstitiel, ladite couche métallique recouvrant au moins partiellement le substrat en carbure ;
- une étape de traitement thermique au cours de laquelle une température supérieure à la température de dissociation du carbure du substrat est appliquée.

L'étape de traitement thermique permet la réaction entre la couche métallique et le substrat en carbure de sorte à former une couche de carbure interstitiel ainsi qu'une première partie d'une couche de graphite à la surface de ladite couche de carbure interstitiel. Elle permet également la formation, lorsque la couche métallique ne recouvre que partiellement le substrat en carbure, d'une deuxième partie de la couche de graphite sur la partie du substrat en carbure non recouverte par la couche métallique. On entend par « la couche étant apte à former un carbure interstitiel » que le matériau composant la couche a une affinité préférentielle pour le carbone. Autrement dit, les conditions de température et de pression lors de la mise en oeuvre du procédé selon l'invention sont choisies de sorte que l'affinité du matériau composant la couche métallique avec le carbone et plus importante que l'affinité dudit matériau avec les autres éléments chimiques composant le substrat en carbure.

Ainsi, il est possible de former une couche de graphite sur une couche de carbure interstitiel sans avoir à appliquer, durant l'étape de traitement thermique, une température supérieure à la température de dissociation du carbure interstitiel. En effet, la seule contrainte concernant la température lors de l'étape de traitement thermique est que la température appliquée doit être supérieure à la température de dissociation du carbure du substrat. On entend par température de dissociation d'un composé, ici le carbure, la température à partir de laquelle les atomes de métal se dissocient du carbure et les atomes de carbone se réorganisent pour former un autre matériau carboné. Cette température dépend de la pression et du gaz utilisé. Par ailleurs, on entend par couche de graphite une couche comprenant une ou plusieurs feuilles de graphène.

Les inventeurs ont par ailleurs constaté que la résistance à l'interface entre la couche de graphite et la couche de carbure interstitiel obtenues à l'issue de l'étape de traitement thermique est très faible. Autrement dit, le procédé ci-dessus peut être utilisé non seulement pour obtenir une couche de graphite sur une couche de carbure interstitiel à une température plus faible que la température de dissociation dudit carbure interstitiel mais également pour fournir un contact électrique en carbure interstitiel ayant une faible résistance de contact avec la couche de graphite.

Pour cela, un deuxième aspect de l'invention concerne un procédé de réalisation d'un contact électrique sur une couche de graphite déposée sur un substrat en carbure comportant :
- une étape de dépôt d'une couche métallique formée de un ou plusieurs métaux sur le substrat en carbure, la couche métallique étant apte à former un carbure interstitiel, ladite couche métallique recouvrant au moins partiellement le substrat en carbure ;
- une étape de structuration de ladite couche métallique, ladite structuration définissant un contact métallique ;
- une étape de traitement thermique au cours de laquelle une température supérieure à la température de dissociation du carbure du substrat est appliquée.

Comme expliqué précédemment, l'étape de traitement thermique permet d'une part la réaction entre le contact métallique et le substrat pour former un contact en carbure interstitiel ainsi qu'une première partie d'une couche de graphite à la surface dudit contact ; et d'autre part la formation d'une deuxième partie de la couche de graphite à la surface du substrat non-recouverte par le contact.

Ainsi, on obtient un contact en carbure interstitiel qui, compte tenu de la faible résistance au niveau de l'interface entre la couche de graphite et la couche de carbure interstitiel composant le contact, possède une faible résistance de contact. En outre, comme détaillé précédemment, la couche de graphite croît non seulement au niveau du contact en carbure interstitiel mais également au niveau de la partie du substrat de carbure non recouverte par ledit contact. Le contact obtenu par le procédé selon un deuxième aspect de l'invention permet donc d'obtenir un contact électrique sur une couche de graphite déposée sur un substrat en carbure. L'expression « un contact électrique sur une couche de graphite » ne doit pas être comprise ici comme la localisation du contact mais signifie que la connexion électrique se fait entre le contact électrique et la couche de graphite. Un tel contact électrique peut ensuite être utilisé afin de fabriquer un dispositif électronique à base de graphite.

Pour cela, un troisième aspect de l'invention concerne un procédé de réalisation d'un dispositif électronique à base de graphite comprenant :
- une étape de dépôt d'une couche métallique formée de un ou plusieurs métaux sur un substrat en carbure, la couche métallique étant apte à former un carbure interstitiel, ladite couche métallique recouvrant au moins partiellement le substrat en carbure ;
- une première étape de structuration de ladite couche métallique, ladite structuration définissant un premier contact métallique et un deuxième contact métallique ;
- une étape de traitement thermique au cours de laquelle une température supérieure à la température de dissociation du carbure du substrat est appliquée.

Comme expliqué précédemment, durant cette étape de traitement thermique, les premier et deuxième contacts métalliques réagissent avec le substrat de carbure pour former un premier et un deuxième contacts de carbure interstitiel ainsi qu'une première partie d'une couche de graphite à la surface desdits contacts. De plus, une deuxième partie de la couche de graphite est formée à la surface du substrat non-recouverte par les premier et deuxième contacts.

Le procédé selon un troisième aspect de l'invention comprend également une deuxième étape de structuration de la couche de graphite présente à la surface du premier contact, du deuxième contact et de la partie non-recouverte du substrat en carbure définissant une partie active reliant le premier contact au deuxième contact.

Ainsi, on obtient un dispositif électronique comprenant deux contacts électriques reliés entre eux par une couche de graphite déposée sur un substrat de carbure. Ce dispositif présente l'avantage de fournir deux bons contacts électriques avec la couche de graphite déposée sur le substrat de carbure.

Un quatrième aspect de l'invention concerne un contact électrique susceptible d'être obtenu à l'aide d'un procédé de fabrication selon un deuxième aspect de l'invention.

Un cinquième aspect de l'invention concerne un dispositif électronique susceptible d'être obtenu à l'aide d'un procédé de fabrication selon un troisième aspect de l'invention.

Outre les caractéristiques qui viennent d'être évoquées dans le paragraphe précédent, le procédé selon un premier aspect de l'invention, un deuxième aspect de l'invention ou un troisième aspect de l'invention peut présenter une ou plusieurs caractéristiques complémentaires parmi les suivantes, considérées individuellement ou selon toutes les combinaisons techniquement possibles.

Avantageusement, la couche de graphite est composée d'une feuille de graphène.

Avantageusement, le carbure du substrat est un carbure moins conducteur, à la température de fonctionnement du contact, que le graphite de la couche de graphite. Autrement dit, la résistivité du carbure du substrat est supérieure à la résistivité du graphite de la couche de graphite, la résistivité étant celle mesurée à la température de fonctionnement du contact selon un deuxième aspect de l'invention ou du dispositif selon un troisième aspect de l'invention. Ainsi, on s'assure que le dispositif n'est pas court-circuité par le substrat.

Avantageusement, le carbure du substrat est un carbure isolant. On entend par «carbure isolant » un carbure dont la résistivité est supérieure à 100 fois, préférentiellement 500 fois, voire 1000 fois la résistivité de la couche de graphite. La résistivité considérée est la résistivité mesurée à la température de fonctionnement de la couche de graphite du contact ou du dispositif obtenu à l'aide d'un procédé selon un deuxième aspect ou un troisième aspect de l'invention.

Avantageusement, le substrat est un substrat de carbure de silicium ou un substrat de carbure d'aluminium.

Avantageusement, le ou les métaux formant la couche métallique sont choisis parmi le Titane (Ti), le Zirconium (Zr), le Hafnium (Hf), le Vanadium (V), le Niobium (Nb), le Tantale (Ta), le Chrome (Cr), le Molybdène (Mo), le Tungstène (W) ou leurs alliages. Ainsi, il est possible d'obtenir des structures hybrides, par exemple semi-conducteur/supraconducteur, semi-conducteur/ferromagnétique, etc.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1A montre un ordinogramme d'un premier mode de réalisation d'un procédé selon un premier aspect de l'invention.
- La figure 1B montre un ordinogramme d'un deuxième mode de réalisation d'un procédé selon un premier aspect de l'invention.
- Les figures 2A à 2C illustrent les différentes étapes d'un premier mode de réalisation d'un procédé selon un premier aspect de l'invention.
- La figure 3 montre un ordinogramme d'un premier mode de réalisation d'un procédé selon un deuxième aspect de l'invention.
- Les figures 4A à 4D illustrent les différentes étapes d'un premier mode de réalisation d'un procédé selon un deuxième aspect de l'invention.
- La figure 5 montre un ordinogramme d'un premier mode de réalisation d'un procédé selon un troisième aspect de l'invention.
- Les figures 6A à 6F illustrent les différentes étapes d'un premier mode de réalisation d'un procédé selon un troisième aspect de l'invention.

### DESCRIPTION DETAILLEE D'AU MOINS UN MODE DE REALISATION DE L'INVENTION

Sauf précision contraire, un même élément apparaissant sur des figures différentes présente une référence unique.

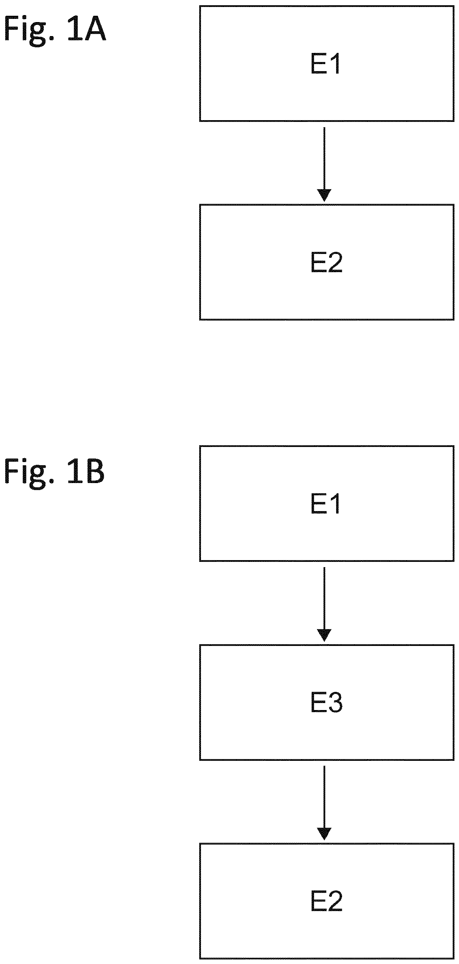

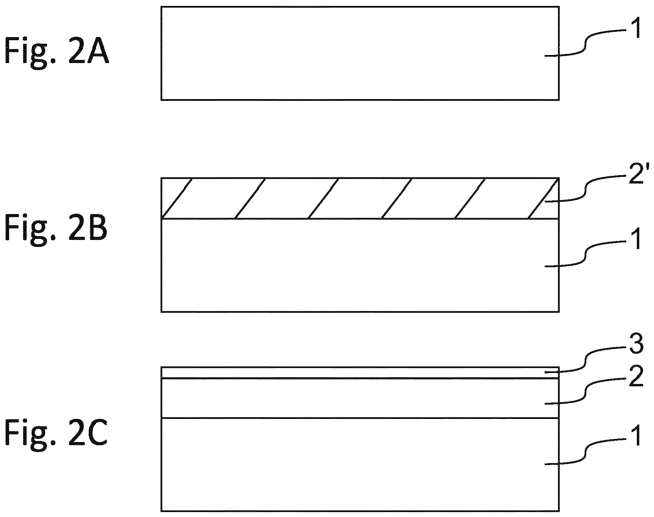

Un premier aspect de l'invention illustré aux figure 1A, 1B et 2A à 2C concerne un procédé de fabrication d'une couche de graphite 3 sur une couche de carbure interstitiel 2. Pour cela, on dispose d'abord d'un substrat 1 de carbure (figure 2A). Le procédé de fabrication comprend :
- une étape E1 de dépôt d'une couche métallique 2' formée de un ou plusieurs métaux sur le substrat 1 en carbure, la couche métallique 2' étant apte à former un carbure interstitiel, ladite couche métallique 2' recouvrant au moins partiellement le substrat 1 en carbure (figure 2B) ;
- une étape E2 de traitement thermique au cours de laquelle une température supérieure à la température de dissociation du carbure du substrat 1 est appliquée (figure 2C).

L'étape E2 de traitement thermique permet d'une part la réaction entre la couche métallique 2' et le substrat 1 pour former une couche de carbure interstitiel 2 ainsi qu'une première partie d'une couche de graphite 3 à la surface de ladite couche de carbure interstitiel 2 ; et d'autre part la formation d'une deuxième partie de la couche de graphite 3 à la surface du substrat 1 non-recouverte par la couche métallique 2' lorsque la couche métallique 2' ne recouvre pas entièrement le substrat 1. La couche 3 obtenue à l'issue de l'étape E2 de traitement thermique est donc continue et couvre la couche de carbure interstitiel 2 ainsi que la partie du substrat 1 non recouverte (lorsque cette dernière existe) par ladite couche de carbure interstitiel 2. On entend par « la couche étant apte à former un carbure interstitiel » que le matériau composant la couche métallique a une affinité préférentielle pour le carbone. Autrement dit, les conditions de température et de pression lors de la mise en oeuvre du procédé selon l'invention sont choisies de sorte que l'affinité du matériau composant la couche métallique avec le carbone et plus importante que l'affinité dudit matériau avec les autres éléments chimiques composant le substrat en carbure.

Dans un premier mode de réalisation selon un premier aspect de l'invention le substrat 1 est un substrat en carbure de silicium (SiC) et la couche métallique 2' est réalisée en niobium (Nb), ce métal étant apte à former un carbure interstitiel à savoir le carbure de niobium (NbC). En effet, le niobium a une affinité plus grande avec le carbone qu'avec le silicium lorsque la température est supérieure à 1200 °C pour une pression de 10⁶mbar ou supérieur à 1300°C pour une atmosphère de gaz inerte (par exemple de l'argon) à une pression égale ou voisine de la pression atmosphérique. Le dépôt peut par exemple être réalisé à l'aide d'un dépôt par effet Joule ou par pulvérisation cathodique. Dans tous les cas, le dépôt est effectué sous une atmosphère contrôlée, de préférence sous vide ou dans une atmosphère comprenant un ou plusieurs gaz. Par exemple, il est possible de procéder à un dépôt par évaporation d'un film de 40 nm de niobium sur le substrat 1 en carbure, la pression pendant le dépôt étant maintenue à 5x10⁻⁷ mbar et la vitesse du dépôt étant de 0,75 nm/s. D'autres méthodes ou paramètres de dépôt peuvent cependant être envisagés en fonction du ou des matériaux déposés ou bien encore de la qualité de surface souhaitée.

Dans ce premier mode de réalisation, l'étape E2 de traitement thermique est effectuée sous vide primaire (c'est-à-dire une pression entre 10⁵ et 10⁻³ Pa) ou secondaire (c'est-à-dire une pression inférieure à 10⁻³ Pa). Elle peut comprendre une première rampe de température élevant la température à 1140°C. Cette rampe peut par exemple avoir une durée de 60 minutes. L'étape E2 de traitement thermique peut également comprendre une deuxième rampe thermique élevant la température à 1360 °C. Cette deuxième rampe peut par exemple avoir une durée de 180 minutes et être suivie par un plateau durant lequel la température est maintenue à 1360 °C, c'est-à-dire au-dessus de la température de dissociation du carbure de silicium, ledit plateau ayant par exemple une durée de 18 minutes. Le plateau en température est alors suivi d'une rampe abaissant la température jusqu'à la température ambiante. Ce retour à la température ambiante peut par exemple être effectué en empruntant les étapes inverses, autrement dit une rampe abaissant la température à 1140°C suivie d'une deuxième rampe abaissant la température jusqu'à la température ambiante.

Dans un deuxième mode de réalisation selon un premier aspect de l'invention illustré à la figure 1B, afin de contrôler plus précisément la croissance du graphite, l'étape E2 de traitement thermique est effectuée sous une atmosphère d'argon (Ar), l'épaisseur de graphite obtenue étant alors plus faible qu'en l'absence d'argon. En outre, cette étape est précédée d'une étape E3 de préparation du substrat 1.

Cette étape E3 de préparation du substrat 1 vise à restructurer la surface du substrat en carbure de silicium avant l'étape E2 de traitement thermique. Cette étape E3 de préparation peut comprendre une première rampe de température élevant la température à 800 °C. La durée de cette rampe peut par exemple être égale à 60 minutes. A l'issue de cette rampe, un mélange gazeux comprenant de préférence 95 % d'argon et 5 % d'hydrogène est introduit dans l'enceinte jusqu'à établir une pression égale à la pression atmosphérique. Un flux constant de ce même mélange gazeux est maintenu durant toute l'étape E3 de préparation du substrat 1. L'étape E3 de préparation du substrat 1 peut également comprendre une rampe de température élevant la température à 1600 °C, la durée de cette rampe étant par exemple de 90 minutes. Cette rampe est alors suivie d'un plateau en température dont la durée est par exemple égale à 30 minutes. Le plateau en température est suivi d'une rampe de température abaissant la température à 800 °C, cette rampe ayant par exemple une durée de 90 minutes. Ceci permet de restructurer la surface de carbure de silicium du substrat 1 sous forme de grandes terrasses régulières et de réduire le nombre de points de nucléation afin de favoriser la croissance d'une seule couche de graphène.

A l'issue de cette étape E3 de préparation du substrat 1, l'étape E2 de traitement thermique est mise en oeuvre. Cette dernière comprend tout d'abord une sous-étape de remplacement du mélange gazeux par de l'argon pur au moyen d'un flux d'argon pur. Une fois le mélange entièrement chassé de l'enceinte dans laquelle est effectuée l'étape E3 de traitement thermique et remplacé par de l'argon, le flux d'argon est stoppé et une atmosphère d'argon statique est maintenue durant tout le reste de l'étape E2 de traitement thermique. Une rampe de température est ensuite effectuée, cette dernière élevant la température à 1600 °C par exemple et ayant par exemple une durée égale à 200 minutes. Cette rampe est suivie d'un plateau en température, ledit plateau ayant par exemple une durée de 30 minutes. A l'issue de ce plateau, une rampe de température est mise en oeuvre durant laquelle la température est abaissée à la température ambiante, cette rampe ayant une durée de 260 minutes par exemple.

Les deux modes de réalisation précédents ne sont qu'une illustration d'un procédé selon un premier aspect de l'invention. Dans ces deux modes de réalisation, le métal utilisé est du niobium. Il est bien évident qu'il ne s'agit là que d'un exemple à but illustratif et que tout métal ou alliage métallique susceptible de former un carbure interstitiel peut être utilisé.

A l'issue du procédé selon un premier ou un deuxième mode de réalisation d'un premier aspect de l'invention, l'empilement obtenu comprend le substrat 1 en carbure de silicium, la couche de carbure de niobium 2 et la couche de graphite 3 (figure 2C). Le nombre de feuilles de graphène composant la couche de graphite 3 est fonction de la durée de l'étape E2 de traitement thermique ainsi que de la température atteinte lors de cette étape E2 de traitement et de l'éventuelle pression d'argon lors de cette E2 de traitement thermique. Ainsi, la couche de graphite 3 peut comprendre une ou plusieurs feuilles de graphène. Il est en outre important de noter que l'interface entre la couche de carbure interstitiel 2 et la couche de graphite 3 présente une faible résistance. Autrement dit, il est possible d'utiliser un tel empilement afin de réaliser un contact électrique avec la couche de graphite 3 obtenue à l'issue de l'étape E2 de traitement thermique.

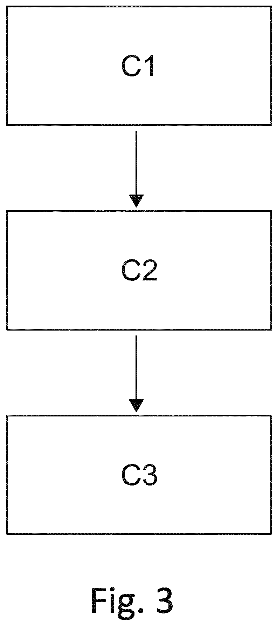

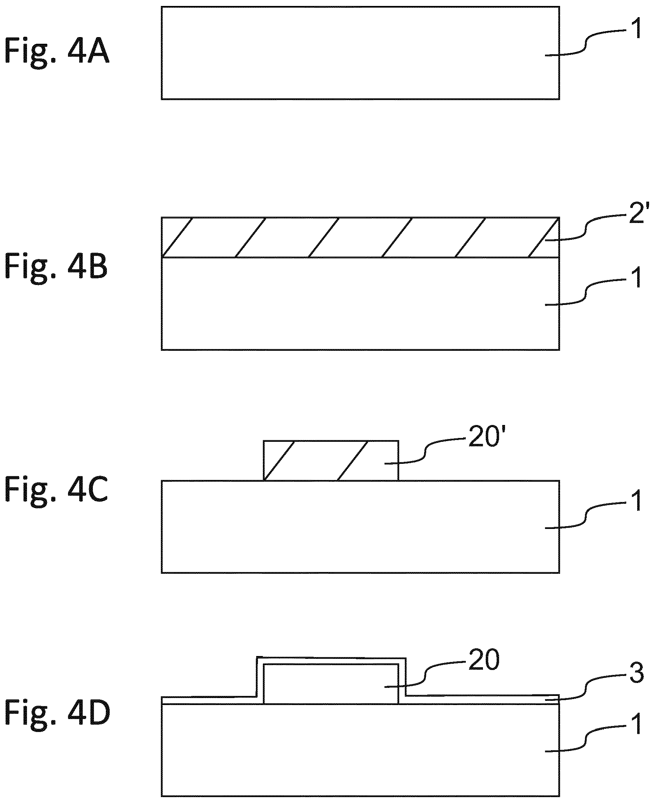

Pour cela, un deuxième aspect de l'invention illustré à la figure 3 et aux figures 4A à 4D concerne un procédé de réalisation d'un contact électrique 20 sur une couche de graphite 3 déposée sur un substrat 1 en carbure. Le procédé comprend :
- une étape C1 de dépôt d'une couche métallique 2' formée de un ou plusieurs métaux sur le substrat 1 en carbure, la couche métallique 2' étant apte à former un carbure interstitiel, ladite couche métallique 2' recouvrant au moins partiellement le substrat 1 en carbure (figure 4B) ;
- une étape C2 de structuration de ladite couche métallique 2', ladite structuration définissant un contact métallique 20' (figure 4C) ;
- une étape C3 de traitement thermique au cours de laquelle la température est supérieure à la température de dissociation du carbure du substrat (figure 4D).

Durant l'étape C3 de traitement thermique, le contact métallique 20' réagit avec le substrat 1 pour former un contact en carbure interstitiel 20 ainsi qu'une première partie d'une couche de graphite 3 à la surface dudit contact 20. De plus une deuxième partie de la couche de graphite 3 se forme à la surface du substrat 1 non-recouverte par le contact 20. La couche 3 de graphite obtenue à l'issue de l'étape C3 de traitement thermique est donc continue et couvre le contact de carbure interstitiel 20 ainsi que la partie du substrat 1 non recouverte par ledit contact de carbure interstitiel 20 (figure 4D).

Dans un premier mode de réalisation selon un deuxième aspect de l'invention, la couche métallique 2' est réalisée en tantale (Ta), ce métal étant apte à former un carbure interstitiel, à savoir le carbure de tantale (TaC). L'étape C2 de structuration de ladite couche métallique 2' permet donc d'obtenir un contact 20' métallique en tantale. Il est évident que si ici un seul contact est évoqué, il est possible de réaliser plusieurs contacts comme cela sera décrit dans la suite.

Dans ce mode de réalisation, l'étape C3 de traitement thermique permet de convertir le contact 20' métallique en tantale en contact en carbure de tantale 20 (figure 4D). Comme évoqué précédemment, la résistance au niveau de l'interface entre le contact en carbure de tantale 20 et la couche de graphite 3 est faible. Le contact en carbure de tantale 20 réalise donc un contact électrique avec la couche de graphite 3 par ailleurs déposée sur le substrat 1 de carbure. Le procédé permet donc de réaliser un contact électrique 20 sur une couche de graphite 3 déposée sur un substrat 1 en carbure. Dans ce premier mode de réalisation, l'étape C3 de traitement thermique est par exemple identique à l'étape E2 de traitement thermique décrite dans le cadre du premier mode de réalisation selon un premier aspect de l'invention, c'est-à-dire effectuée sous vide primaire ou secondaire.

Cependant, dans un deuxième mode de réalisation selon un deuxième aspect de l'invention, l'étape C3 de traitement thermique peut être identique à l'étape E2 de traitement thermique décrite dans le cadre du deuxième mode de réalisation selon un premier aspect de l'invention, c'est-à-dire, sous une atmosphère d'argon. Dans ce cas, cette étape C3 de traitement thermique sera de préférence immédiatement précédée d'une étape de préparation du substrat 1 comme présenté dans le deuxième mode de réalisation selon un premier aspect de l'invention, c'est-à-dire sous une atmosphère d'un mélange gazeux d'hydrogène et d'argon.

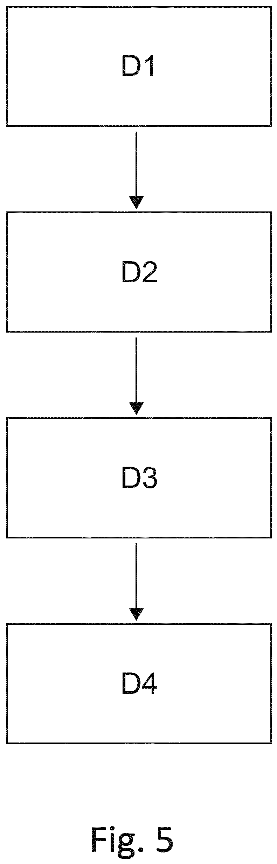

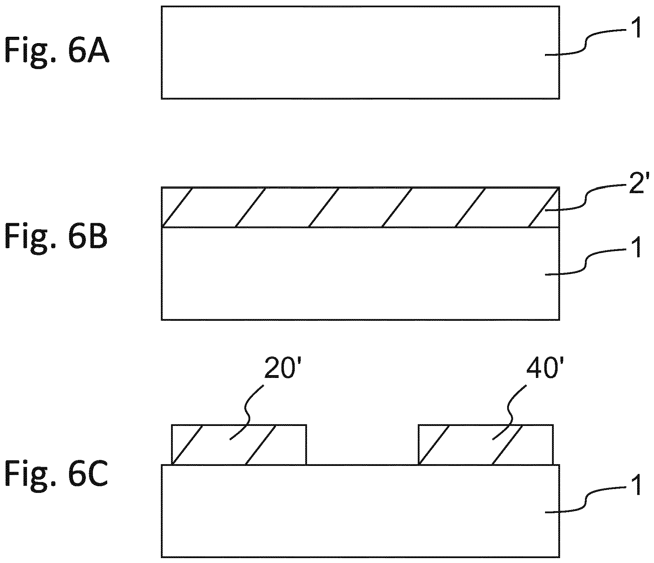

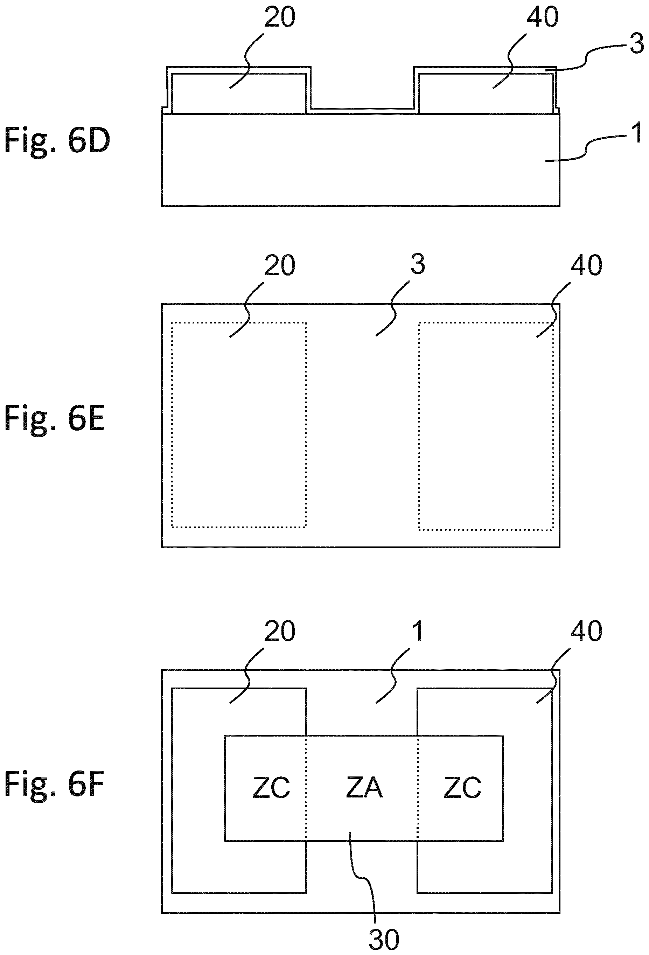

Il est ensuite possible d'utiliser de tels contacts afin de fabriquer un dispositif à base de graphite. Pour cela, un troisième aspect de l'invention illustré aux figures 5 et 6A à 6F concerne un procédé de réalisation d'un dispositif électronique à base de graphite. A cet effet, on dispose tout d'abord d'un substrat 1 en carbure (figure 6A). Le procédé comprend :
- une étape D1 de dépôt d'une couche métallique 2' formée de un ou plusieurs métaux sur un substrat 1 en carbure, la couche métallique 2' étant apte à former un carbure interstitiel, ladite couche métallique 2' recouvrant au moins partiellement le substrat 1 en carbure (figure 6B).
- une première étape D2 de structuration de ladite couche métallique 2', ladite structuration définissant un premier contact 20' métallique et un deuxième contact 40' métallique (figure 6C).
- une étape D3 de traitement thermique au cours de laquelle une température supérieure à la température de dissociation du carbure du substrat 1 est appliquée (figures 6D et 6E).

Lors de cette étape D3 de traitement thermique, les premier 20' et deuxième 40' contacts métalliques réagissent avec le substrat 1 de carbure pour former un premier 20 et un deuxième 40 contacts de carbure interstitiel ainsi qu'une première partie d'une couche de graphite 3 à la surface desdits contacts 20,40. En outre, durant cette même étape, une deuxième partie de la couche de graphite 3 est formée à la surface du substrat 1 non-recouverte par les premier et deuxième contacts 20,40.

Comme illustré à la figure 6E, la couche de graphite 3 obtenue à l'issue de l'étape D3 de traitement thermique est donc continue et couvre le premier contact 20, le deuxième contact 40 de carbure interstitiel ainsi que la partie du substrat 1 non recouverte par lesdits contacts de carbure interstitiel 20,40. Autrement dit, la couche de graphite 3 recouvre la totalité du substrat 1 et des deux contacts 20, 40. Or une telle configuration ne constitue pas un dispositif électronique en tant que tel.

Afin d'obtenir un dispositif électronique, le procédé comprend donc une deuxième étape D4 de structuration de la couche de graphite 3 présente à la surface du premier contact 20, du deuxième contact 40 et de la partie exposée de la surface du substrat 1 en carbure qui permet de définir une partie active reliant le premier contact au deuxième contact (figure 6F).

Comme illustré à la figure 6F, à l'issue du procédé selon un troisième aspect de l'invention, on obtient un dispositif comprenant un premier contact 20 (ou première électrode) et un deuxième contact 40 (ou deuxième électrode). Ces deux électrodes sont connectées électriquement avec un ruban de graphite 30 par l'intermédiaire de deux zones de contact ZC. Ces deux zones de contact ZC sont séparées par une zone active ZA constituée par la partie centrale du ruban de graphite 30. Le procédé permet donc de réaliser un dispositif électronique à base de graphite sur un substrat 1 en carbure.

Dans un premier mode de réalisation selon un troisième aspect de l'invention, la couche métallique 2' est réalisée par exemple en niobium (Nb) ce métal étant apte à former un carbure interstitiel, à savoir le carbure de niobium (NbC). L'étape D2 de structuration de ladite couche métallique 2' permet alors d'obtenir un premier contact métallique et un deuxième contact métallique en niobium.

Dans ce mode de réalisation, l'étape D3 de traitement thermique permet de convertir le premier contact 20' métallique et le deuxième contact 40' métallique en niobium en premier contact 20 et deuxième contact 40 en carbure de niobium. Comme évoqué précédemment, la résistance au niveau de l'interface entre lesdits contacts 20,40 en carbure de niobium et la couche de graphite 3 est faible. Dans ce premier mode de réalisation, cette étape D3 de traitement thermique est par exemple identique à l'étape E2 de traitement thermique décrite dans le cadre du premier mode de réalisation selon un premier aspect de l'invention, c'est-à-dire effectuée sous vide primaire ou secondaire.

Cependant, il est également possible d'envisager un deuxième mode de réalisation dans lequel l'étape D3 de traitement thermique est identique à l'étape E2 de traitement thermique décrite dans le cadre du deuxième mode de réalisation selon un premier aspect de l'invention, c'est-à-dire sous une atmosphère d'argon. Dans ce cas, cette étape D3 de traitement thermique sera de préférence immédiatement précédée d'une étape de préparation du substrat comme présenté dans le deuxième mode de réalisation selon un premier aspect, c'est-à-dire sous une atmosphère d'un mélange gazeux d'hydrogène et d'argon.

Dans les deux modes de réalisation selon un troisième aspect de l'invention que l'on vient de présenter, la couche métallique 2' est réalisée en niobium, cette couche venant former, après la première étape D2 de structuration et l'étape D3 de traitement thermique, deux contacts 20,40 en carbure de niobium. Or, il est connu que le carbure de niobium, à basse température (inférieure à 12 K), est un matériau supraconducteur. Autrement dit, le procédé qui vient d'être décrit permet d'obtenir un dispositif dit hybride mettant en jeu un matériau supraconducteur au niveau du premier contact 20 et du deuxième contact 40 ainsi qu'un matériau conducteur au niveau du ruban de graphite 30, ledit ruban de graphite 30 étant quant à lui obtenu à l'issue de la deuxième étape C4 de structuration. Un tel dispositif hybride pourrait notamment être employé dans le cadre de l'ingénierie quantique et la réalisation de circuits quantiques supraconducteurs pour l'optique quantique et la métrologie.

Cependant, comme évoqué précédemment, le niobium n'est pas le seul matériau qui puisse être utilisé dans le cadre de l'invention. En effet, tout matériau permettant la formation d'un carbure interstitiel peut être employé. Par exemple, il est possible d'utiliser une couche métallique 2' comprenant du fer (Fe), cet élément étant apte à former un carbure appelé cémentite. Or, la cémentite est un matériau ferromagnétique dont la température de Curie est égale à 200 °C environ : ce matériau est donc ferromagnétique à température ambiante. Il est donc possible de fabriquer, à l'aide du procédé selon un troisième aspect de l'invention, un dispositif hybride mettant en jeu un matériau ferromagnétique au niveau du premier contact 20 et du deuxième contact 40 ainsi qu'un matériau conducteur au niveau du ruban de graphite 30. Un tel dispositif hybride pourrait notamment être employé dans la fabrication de composants spintroniques, c'est à dire des composants utilisant, en plus de la charge, le spin électronique comme support de l'information.

## Revendications

1. Procédé de fabrication d'une couche de graphite (3) sur une couche de carbure interstitiel (2) **caractérisé en ce qu'**il comprend :
- une étape (E1) de dépôt d'une couche métallique (2') formée de un ou plusieurs métaux sur un substrat (1) en carbure, la couche métallique (2') étant apte à former un carbure interstitiel, ladite couche métallique (2') recouvrant au moins partiellement le substrat (1) en carbure ;
- une étape (E2) de traitement thermique au cours de laquelle une température supérieure à la température de dissociation du carbure du substrat (1) est appliquée ;
l'étape (E2) de traitement thermique permettant d'une part la réaction entre la couche métallique (2') et le substrat (1) pour former une couche de carbure interstitiel (2) ainsi qu'une première partie d'une couche de graphite (3) à la surface de ladite couche de carbure interstitiel (2) ; et d'autre part, lorsque la couche métallique (2') ne recouvre que partiellement le substrat (1) en carbure, la formation d'une deuxième partie de la couche de graphite (3) à la surface du substrat (1) non-recouverte par la couche métallique (2').

2. Procédé de réalisation d'un contact électrique sur une couche de graphite (3) déposée sur un substrat (1) en carbure **caractérisé en ce qu'**il comporte :
- une étape (C1) de dépôt d'une couche métallique (2') formée de un ou plusieurs métaux sur le substrat (1) en carbure , la couche métallique (2') étant apte à former un carbure interstitiel, ladite couche métallique (2') recouvrant au moins partiellement le substrat (1) en carbure ;
- une étape (C2) de structuration de ladite couche métallique (2'), ladite structuration définissant un contact (20') métallique ;
- une étape (C3) de traitement thermique au cours de laquelle une température supérieure à la température de dissociation du carbure du substrat (1) est appliquée ;
l'étape (C3) de traitement thermique permettant d'une part la réaction entre le contact métallique (20') et le substrat (1) pour former un contact en carbure interstitiel (20) ainsi qu'une première partie d'une couche de graphite (3) à la surface dudit contact (20) ; et d'autre part la formation d'une deuxième partie de la couche de graphite (3) à la surface du substrat (1) non-recouverte par le contact (20).

3. Procédé de réalisation d'un dispositif électronique à base de graphite **caractérisé en ce qu'**il comprend :
- une étape (D1) de dépôt d'une couche métallique (2') formée de un ou plusieurs métaux sur un substrat (1) en carbure, la couche métallique (2') étant apte à former un carbure interstitiel, ladite couche métallique (2') recouvrant au moins partiellement le substrat (1) en carbure ;
- une première étape (D2) de structuration de ladite couche métallique (2'), ladite structuration définissant un premier contact (20') métallique et un deuxième contact (40') métallique ;
- une étape (D3) de traitement thermique au cours de laquelle une température supérieure à la température de dissociation du carbure du substrat (1) est appliquée et :
▪ les premier (20') et deuxième (40') contacts métalliques réagissent avec le substrat (1) de carbure pour former un premier (20) et un deuxième (40) contact de carbure interstitiel (2) ainsi qu'une première partie d'une couche de graphite (3) à la surface desdits contacts (20,40) ;
▪ une deuxième partie de la couche de graphite (3) est formée à la surface du substrat (1) non-recouverte par les premier et deuxième contacts (20,40) ;
- une deuxième étape (D4) de structuration de la couche de graphite (3) présente à la surface du premier contact (20), du deuxième contact (40) et de la partie non-recouverte du substrat (1) en carbure définissant une partie active reliant le premier contact (20) au deuxième contact (40).

4. Procédé selon la revendication 2 ou la revendication 3 **caractérisé en ce que** le carbure du substrat (1) est un carbure moins conducteur, à la température de fonctionnement du contact, que le graphite de la couche de graphite (3).

5. Procédé selon l'une des revendications précédentes **caractérisé en ce que** la couche de graphite (3) est composée d'une feuille de graphène.

6. Procédé selon l'une des revendications précédentes **caractérisé en ce que** le substrat (1) est un substrat de carbure de silicium ou un substrat de carbure d'aluminium.

7. Procédé selon l'une des revendications précédentes **caractérisé en ce que** le ou les métaux formant la couche métallique (2') sont choisis parmi le Titane (Ti), le Zirconium (Zr), le Hafnium (Hf), le Vanadium (V), le Niobium (Nb), le Tantale (Ta), le Chrome (Cr), le Molybdène (Mo), le Tungstène (W) ou leurs alliages.

8. Contact électrique susceptible d'être obtenu par le procédé de réalisation d'un contact électrique selon la revendication 2 ou l'une des revendications 4 à 7 dans leur dépendance à la revendication 2.

9. Dispositif électronique susceptible d'être obtenu par le procédé de réalisation d'un dispositif électronique à base de graphite selon la revendication 3 ou l'une des revendications 4 à 7 dans leur dépendance à la revendication 3.
